# EUROPÄISCHE PATENTSCHRIFT

(11) **EP 2 539 182 B1**
(45) Veröffentlichungstag und Bekanntmachung des Hinweises auf die Patenterteilung: **15.04.2015**
(21) Anmeldenummer: 11704609.4
(22) Anmeldetag: 18.02.2011
(51) Int. Cl.: B60R 16/00, H03K 17/00

(54) **INNENAUSSTATTUNGSTEIL SOWIE AUßENVERKLEIDUNGSTEIL EINES FAHRZEUGS MIT EINEM ULTRASCHALLSENSOR**
VEHICLE INTERIOR TRIM PANEL WITH AN ULTRASOUND SENSOR
PARTIE D'ÉQUIPEMENT INTÉRIEUR ET PARTIE D'HABILLAGE EXTÉRIEUR D'UN VÉHICULE AVEC UN CAPTEUR À ULTRASONS

(30) Priorität: 24.02.2010 DE 102010002282
(43) Veröffentlichungstag der Anmeldung: 02.01.2013
(73) Patentinhaber: Lisa Dräxlmaier GmbH, 84137 Vilsbiburg (DE)
(72) Erfinder: STECKEL, Michael, 84137 Vilsbiburg (DE)
(74) Vertreter: Buchholz, Thomas
(86) Internationale Anmeldenummer: PCT/EP2011/052427
(87) Internationale Veröffentlichungsnummer: WO 2011/104185

(56) Entgegenhaltungen:
- WO-A1-02/33203
- WO-A2-02/37516
- DE-A1- 4 004 353
- DE-A1- 19 921 285
- DE-A1-102004 009 208
- DE-A1-102006 012 336
- DE-A1-102007 013 078
- DE-A1-102007 028 063
- US-A- 5 149 986

## Beschreibung

Die vorliegende Erfindung betrifft Innenausstattungsteile von Fahrzeugen und hier insbesondere Kraftfahrzeugen. Bei Innenausstattungsteilen kann es sich beispielsweise um Türinnenverkleidungen, Mittelkonsolen, Instrumententafeln, den Bachhimmel oder vergleichbare Teile handeln. Insbesondere betrifft die Erfindung dabei ein Innenausstattungsteil mit den Merkmalen im Oberbegriff von Anspruch 1. Darüber hinaus kann die vorliegende Erfindung auch bei Außenverkleidungsteilen eines Fahrzeugs, wie beispielsweise einem Stoßfänger zum Einsatz kommen.

In Fahrzeugen können eine Vielzahl von Stellfunktionen oder Ein- und Ausschaltbefehlen für verschiedenartige Bauelemente über Betätigungselemente angewählt, aktiviert oder deaktiviert werden. So ist es beispielsweise üblich, die Fenster, das Schiebedach, die Außenspiegel oder dergleichen mittels elektrisch betätigter Stellmotoren zu verstellen, zu heben, zu senken oder zu öffnen und zu schließen. Darüber hinaus sind in Fahrzeugen eine Vielzahl von Funktionstasten vorgesehen, über die die elektrischen Verbraucher beispielsweise Heizungen, Lüftungen, Lichtelemente, Multimediaanlagen, Bordcomputer, Navigationssysteme und dergleichen angeschaltet oder in jeder erdenklichen Weise verstellbar sind.

Die Betätigungselemente für derartige Bauelemente und Verbraucher sind beispielsweise in der Mittelkonsole, in der Instrumententafel und/oder im oder am Lenkrad sowie in der Türverkleidung vorgesehen.

Die Ausgestaltung der verschiedenen Betätigungselemente erfolgt dabei nicht allein unter dem Gesichtspunkt einer vorteilhaften Funktionsweise und Ergonomie, sondern auch einer vorteilhaften Optik. Hierzu ist es insbesondere im Bereich der Instrumententafel und des Lenkrads üblich, dass die Betätigungselemente innerhalb einer Dekorschicht angeordnet sind.

Die neuere Entwicklung geht dahin, die Betätigungselemente in Form von kapazitiven oder drucksensitiven Tasten, z. B. piezoelektrischen Tasten, vorzusehen, die unter der Dekorschicht bzw. unter einer im Wesentlichen kontinuierlich geschlossenen Sichtseite der Dekorschicht angeordnet sind. Die Sichtseite bezeichnet dabei die Seite des Dekors, die von einem Betrachter, dem Nutzer des Betätigungselements, wahrgenommen, d. h. gesehen, wird. Dies hat sowohl optische wie auch funktionale Vorteile, die durch die nahtlosen bzw. spaltlosen Übergänge zwischen einzelnen Betätigungselementen und dem Dekor erzielbar sind. Bezüglich derart ausgestalteter Innenausstattungsteile wird auf die DE 10 2007 054 347 B3 sowie die DE 103 59 297 A1 verwiesen.

Darüber hinaus ist es bei neueren Ausgestaltungen bevorzugt, die Betätigungselemente so anzuordnen, dass ein sogenannter Verschwindeeffekt oder auch Black-Panel-Effekt erzielt wird. D. h. die Bedienelemente bzw. deren Symbolik sind zunächst nicht sichtbar und das Dekor erscheint in einer kontinuierlichen ununterbrochenen Darstellung. Erst bei einer Annäherung des Bedieners an das entsprechende Bedien- bzw. Betätigungselement wird die Symbolik erleuchtet und das jeweilige Bedienelement wird oder die Bedienelemente werden sichtbar. Diesbezüglich wird auf die DE 10 2007 013 078 A1 verwiesen.

Bisher kamen im Stand der Technik zu diesem Zweck kapazitive Näherungssensoren zum Einsatz. Kapazitive Näherungssensoren haben jedoch den Nachteil, dass Ihre Reichweite sehr eingeschränkt ist. Dadurch wird der Verschwindeeffekt bzw. Black-Panel-Effekt (d. h. das Aufleuchten der Symbolik bei Annäherung einer Hand) nicht voll ausgenutzt, da die Symbolik beim sichtbar werden bereits durch die Hand des Nutzers verdeckt wird. Darüber hinaus reagieren kapazitive Sensoren nur auf elektrisch leitendes Material, so dass beispielsweise Prothesen nicht erkannt werden können.

Ferner soll eine vergleichbare Funktion in Ablagefächern (z. B. in Türinnenverkleidungen) genutzt werden können. So könnte beispielsweise eine Ausleuchtung der Fächer vorgesehen werden, die nach Möglichkeit nur dann eingeschaltet werden soll, wenn Zugang zu dem entsprechenden Fach gewünscht wird, d. h. also auch hier eine Annäherung der Hand an das entsprechende Fach statt findet.

Ferner offenbart die WO-A-02/37516 A2 einen elektrischen Schalter, bei dem ein Verbund aus einem Dekor und einem Träger in einem Teilbereich ausgedünnt ist, wobei in dem Teilbereich ein Ausschnitt vorgesehen ist, der von einem Leuchtkörper durchragt wird. Der Leuchtkörper weist ein integral mit dem Leuchtkörper ausgebildetes Druckstück auf, das auf einen Piezosensor wirkt. Betätigt ein Nutzer den Leuchtkörper, so wird der Druck auf den Piezosensor übertragen und ein elektrisches Schaltsignal ausgelöst. Ferner kann eine taktile Rückmeldung in Form eines Ultraschallgebers vorgesehen sein, der direkt oder indirekt auf den Leuchtkörper wirkt und die Sichtfläche des Leuchtkörpers, nicht aber den Verbund aus Dekor und Träger in Vibration versetzt.

Darüber hinaus ist die Verwendung eines Ultraschallsensors für einen elektrischen Schalter aus der US-A-5,149,986 bekannt, wobei die Ultraschallwellen eines Ultraschallsensors über eine Glaskugel übertragen werden. Durch Berühren der Glaskugel wird eine Änderung erfasst und ein Schaltvorgang ausgelöst. Die Kugel ist in einem Gehäuse gehalten und liegt im Bereich eines Berührungspunkts frei.

Die Aufgabe der vorliegenden Erfindung beruht angesichts der obigen Ausführungen darin, ein Innenausstattungsteil der eingangs genannten Art derart weiterzubilden, dass das Eingreifen eines Nutzens in einen relativ großen überwachten Raum bzw. Bereich erkennbar ist ohne das optische Erscheinungsbild des Dekors, insbesondere in Bezug auf dessen kontinuierlich geschlossenen Oberfläche aufgeben zu müssen.

Diese Aufgabe wird durch ein Innenausstattungsteil mit den Merkmalen des Anspruchs 1 gelöst. Vorteilhafte Ausgestaltungen finden sich in den Unteransprüchen. Darüber hinaus hat sich als vorteilhafter Nebeneffekt die Verwendung des Erfindungsgedanken in Außenverkleidungsteilen von Fahrzeugen ergeben, wie sie in Anspruch 12 und den folgenden abhängigen Ansprüchen definiert sind.

Der Grundgedanke der vorliegenden Erfindung liegt darin, als Näherungssensor einen Ultraschallsensor zu verwenden und diesen derart vollflächig mit der Rückseite des Innenausstattungsteils zu verbinden, dass das Innenausstattungsteil bzw. ein Teil davon als Membran des Ultraschallsensors fungiert. Dadurch kann die kontinuierlich geschlossene Oberfläche des Dekors beibehalten werden, so dass optisch keine Beeinträchtigung gegenüber dem Stand der Technik auftritt. Im Prinzip ist die Verwendung von Ultraschallsensoren nur in Zusammenhang mit einer "freien Sicht" auf den zu überwachenden Raum bzw. Bereich bekannt.

Es ist bekannt, vgl. DE 10 2007 028 063 A1, Figuren 7A und 7B, gemäß Oberbegriff des Anspruchs 1 der vorliegenden Erfindung dass der Ultraschallsensor hinter geschlossenen Oberflächen angeordnet werden kann. Überraschenderweise hat sich jedoch herausgestellt, dass sich bei Anordnung hinter einer Schicht mit einer geschlossenen Oberfläche und einer entsprechend geringen Stärke von in der Regel weniger als 3 mm die Schicht als Membran des Ultraschallsensors nutzen lässt. Dieser überraschende Effekt liegt der vorliegenden Erfindung zu Grunde.

Dementsprechend schlägt die vorliegende Erfindung, siehe Anspruch 1, ein Innenausstattungsteil eines Fahrzeugs, insbesondere eines Kraftfahrzeugs, vor. Bei dem Innenausstattungsteil kann es sich beispielsweise um die Instrumententafel, die Mittelkonsole, den Dachhimmel, Türinnenverkleidungen handeln, ohne dass diese Aufzählung abschließend ist. Das Innenausstattungsteil umfasst einen Verbund mit einem Träger und einem Dekor auf einer Seite des Trägers. Das Dekor kann unmittelbar auf den Träger kaschiert sein, d. h. mit diesem verbunden. Alternativ ist es auch denkbar, eine oder mehrere Zwischenschichten, z. B. eine Haptikschicht in Form einer Abstandsschicht (z. B. eines Abstandsgewirkes), vorzusehen. Eine solche Schicht ermöglicht es, die Haptikeigenschaften des Dekors zu verbessern. Bei dem Träger wird es sich in der Regel um ein Kunststoffteil, insbesondere ein Spritzgussteil handeln. Es sind jedoch auch andere Trägermaterialien beispielsweise aus Naturfasern oder Naturfaserverbundwerkstoffen denkbar. Als Dekor kommen Kunststofffolien, Leder, künstliches Leder (auch als Planware bezeichnet), Holz, Metalle, wie beispielsweise Aluminium, aber auch Stein in Frage. Das Dekor weist vorzugsweise zwei Seiten auf, von denen eine dem Träger zugewandt (gegebenenfalls mit dem Träger verbunden) ist und die andere eine Sichtseite bildet. Unter einer Sichtseite im Sinne der vorliegenden Erfindung ist die Seite zu verstehen, die im verbauten Zustand des Innenausstattungsteils von einem Betrachter wahrgenommen werden kann. Das Dekor kann zu einer etwaigen Stabilisierung oder zum Schutz überlackiert oder anderweitig beschichtet sein. Bevorzugterweise ist ein solcher Überzug elastisch gestaltet und bevorzugterweise transparent oder zumindest transluzent, so dass die Sichtseite sichtbar bleibt. Im Folgenden wird eine solche Beschichtung als Teil des Dekors verstanden. In zumindest einem Teilbereich ist das Dekor erfindungsgemäß mit einer im Wesentlichen kontinuierlich geschlossenen Oberfläche versehen. Eine kontinuierlich geschlossene Oberfläche ist in diesem Zusammenhang eine Oberfläche, die keine Durchgangsöffnungen von einer Seite des Verbunds zur anderen Seite aufweist. Der Begriff "im Wesentlichen" ist diesbezüglich derart zu verstehen, dass z. B. bei Werkstoffen wie Holz oder Stein möglicherweise vorhandene natürliche Poren nicht dazu führen, dass die Oberfläche nicht kontinuierlich geschlossen ist. Vielmehr ist dies so zu verstehen, dass an keiner Stelle des Teilbereichs eine "freie Sicht" (Durchsicht) von einer Seite zur anderen Seite gegeben ist. Ein großmaschiges Textil ist z. B. ausgeschlossen. Gemäß der vorliegenden Erfindung ist der Verbund innerhalb des Teilbereichs von der der Sichtseite abgewandten Seiten her normal zur Sichtseite ausgedünnt. D. h. innerhalb des Teilbereichs weist der Verbund eine geringere Restwandstärke als in übrigen Bereichen auf. Hierzu können der Träger und/oder das Dekor entsprechend ausgedünnt (z. B. durch Materialabtrag oder werkzeugfallend) sein. Die Ausdünnung erfolgt derart, dass der ausgedünnte Bereich ultraschallschwingfähig ist. Dies kann durch zusätzliche gezielt eingebrachte Schwächungen, z. B. Perforationen oder Schwächungslinien beeinflusst werden, die von der der Sichtseite abgewandten Seite her eingebracht werden und die Sichtseite nicht erreichen. Der ausgedünnte Bereich kann dabei in einer Sicht normal zur Sichtseite kreisförmig, oval, d. h. ellipsenförmig, aber auch recht- oder mehreckig gestaltet sein. Darüber hinaus sind auch abstrakte Konturen denkbar. Des Weiteren ist erfindungsgemäß ein Ultraschallsensor vorgesehen, der einen Ultraschallgeber und vorzugsweise eine Steuerungselektronik zum Steuern und Auswerten umfasst. Der Ultraschallgeber ist in dem ausgedünnten Bereich vollflächig mit der der Sichtseite abgewandten Seite des Verbunds verbunden. Ist beispielsweise im Bereich der Ausdünnung der Träger vollständig ausgespart, so erfolgt die vollflächige Verbindung mit der der Sichtseite des Dekors abgewandten Seite des Dekors. Hier kann das Dekor in diesem Bereich zusätzlich ausgedünnt sein, insofern die Stärke des Dekors noch zu groß ist, als dass das Dekor schwingfähig wäre. Gemäß einer bevorzugten Ausführungsform kann das Dekor in dem ausgedünnten Bereich daher zumindest partiell ausgedünnt sein. Ist der Träger nur teilweise ausgedünnt und bleibt eine Restwandstärke des Trägers bestehen, so wird der Ultraschallgeber an der der Sichtseite abgewandten Seite des Trägers angebracht sein. Gegebenenfalls kann auch eine Verbindung mit der dem Träger zugewandten Seite einer etwaig vorhandenen Zwischenschicht erfolgen. Durch die erfindungsgemäße Ausgestaltung und insbesondere die vollflächige Verbindung des Ultraschallgebers mit der der Sichtseite abgewandten Seite des Verbunds im ausgedünnten Bereich, der ultraschallschwingfähig ist, wird zumindest ein Teil des ausgedünnten Bereichs des Verbunds als Membran des Ultraschallsensors verwendet. Diese schwingt im Gebrauch mit einer Frequenz im Ultraschallbereich und sendet Ultraschallwellen aus. Des Weiteren wird sie durch die reflektierten Ultraschallwellen in Schwingung versetzt, was durch den Ultraschallgeber erkannt wird und über die Elektronik auswertbar ist, um auf einen Eingriff in den überwachten Raum bzw. Bereich zu schließen und eine entsprechende Funktion, z. B. die Erleuchtung einer Symbolik, wie es in der DE 10 2007 013 078 A1 beschrieben ist, zu bewirken, oder um beispielsweise eine Beleuchtung einer Kartentasche zu aktivieren. Durch die erfindungsgemäße Ausgestaltung wird ein Innenausstattungsteil geschaffen, das nach wie vor die hohen Anforderungen an Optik und Funktionalität erzielt und gleichzeitig einen Näherungssensor umfasst, der in einem Entfernungsbereich von bis zu 1 m Eingriffe in einen überwachten Bereich erkennt.

Gemäß einer Ausführungsform ist es denkbar, dass der Ultraschallgeber einen keramischen, insbesondere einen piezoelektrischen Geber aufweist, der vollflächig mit der der Sichtseite abgewandten Seite des Verbunds, d. h. dem Dekor oder dem Träger verbunden ist, so dass zumindest ein Abschnitt des ausgedünnten Bereichs des Verbunds als Membran des Ultraschallgebers fungiert. Dies führt dazu, dass auf eine separate Membran des Ultraschallgebers verzichtet werden kann, da diese durch den Verbund selbst, insbesondere nur das Dekor gebildet wird. Dadurch können die Anzahl der Teile reduziert und die Fertigungskosten minimiert werden.

Alternativ ist es auch denkbar, einen herkömmlichen Ultraschallsensor zu verwenden, der neben dem keramischen, insbesondere dem piezoelektrischen, Geber eine Membran aufweist. Bei dieser Ausführungsform ist es bevorzugt, dass die Membran einerseits mit dem Geber und andererseits mit der der Sichtseite abgewandten Seite des Verbunds verbunden ist, d. h. dem Dekor oder dem Träger oder einer etwaig vorhandenen Zwischenschicht, so dass sich die Schwingung der Membran auf zumindest einen Abschnitt des ausgedünnten Bereichs des Verbunds fortsetzt. Dies hat den Vorteil, dass herkömmliche Ultraschallsensoren ohne wesentliche Abwandlung zugekauft werden können, was die Entwicklungs- und Fertigungskosten minimiert.

Gemäß einer besonders bevorzugten Ausführungsform erfolgt die Verbindung zwischen Ultraschallgeber und der der Sichtseite abgewandten Seite des Verbunds stoffschlüssig. Beispielsweise kann ein Verschweißen der Materialien erfolgen. Bevorzugterweise ist jedoch eine Klebeverbindung vorgesehen.

Des Weiteren ist es bevorzugt, für die vorliegende Erfindung einen topfförmigen Ultraschallsensor zu verwenden, so dass der Ultraschallsensor ein zylinderförmiges Element aufweist. Weist der Ultraschallsensor eine separate Membran auf, so schließt die Membran ein Ende des zylinderförmigen Elements ab, um den Topf zu bilden. Insofern zumindest ein Abschnitt des ausgedünnten Bereichs des Verbunds die Membran bildet, ist das zylinderförmige Element mit der der Sichtseite abgewandten Seite des Verbunds verbunden, insbesondere stoffschlüssig und am meisten bevorzugt verklebt. Somit wird ein Ende des zylinderförmigen Elements von dem als Membran fungierenden Abschnitts des ausgedünnten Bereichs des Verbunds verschlossen, um den Topf zu bilden.

Wie es eingangs erwähnt wurde, ist es bevorzugt, die vorliegende Erfindung im Bereich der Mittelkonsole oder im zentralen Bereich der Armaturentafel, also im Sichtbereich einzusetzen und einen Bereich bzw. Raum unmittelbar vor einem Bedienfeld mit mehreren Bedienelementen zu überwachen. Besonders bevorzugt ist es, hier ein Bedienfeld mit einem Verschwindeeffekt ähnlich der Ausgestaltung wie sie in der DE 10 2007 013 078 A1 beschrieben ist, vorzusehen. Mit anderen Worten ist das Bedienfeld so angeordnet und beleuchtbar, dass es im Ruhezustand (Standby) nicht sichtbar ist. Nähert sich z. B. eine Hand dem Bedienfeld, wird die Symbolik erleuchtet und das Bedienfeld sichtbar. Zu diesem Zweck soll ein Raum unmittelbar vor dem Bedienfeld überwacht werden, ohne dass jedoch normale Bewegungen des Fahrers oder Beifahrers zu einer Erleuchtung der Symbolik führen. Zu diesem Zweck ist es bevorzugt, dass der Ultraschallsensor eine astigmatische Sende-/Empfangscharakteristik aufweist und besonders bevorzugt, dass er eine ellipsoide Sende-/Empfangskeule aufweist, bei der die lange Halbachse in Fahrzeugslängsrichtung und die kurzen Halbachsen in Fahrzeugquerrichtung sowie Fahrzeughöhenrichtung bzw. Fahrzeugvertikalrichtung verlaufen. Dadurch wird eine große Entfernung unmittelbar vor dem Bedienfeld in Fahrzeuglängsrichtung überwacht, während in Quer- und Vertikalrichtung nur relativ kleine Bereiche überwacht werden können. Dadurch löst nur ein gezielter Eingriff in Richtung des Bedienfelds das Erleuchten der Symbolik aus. Bei anderen Anwendungsgebieten oder Einbausituationen (z.B. Kartentasche) kann es notwendig sein, die Sende-/Empfangskeule an die Gegebenheiten anzupassen, d.h. die lange Halbachse liegt dann z.B. nicht mehr in Fahrzeug-Längsrichtung, sondern quer dazu. Je nach Situation ist die Sende-/Empfangscharakteristik frei wählbar. Um die Sende-/Empfangscharakteristik zu beeinflussen, kann es gegebenenfalls vorteilhaft sein, von der der Sichtseite abgewandten Seite her gezielte Aussparungen, z. B. linienförmige Kerben in dem ausgedünnten Bereich vorzusehen, wie es beispielsweise aus der EP 0 308 899 A2 bekannt ist.

Darüber hinaus hat es sich als besonders bevorzugt erwiesen, dass die Restwandstärke des Verbunds im ausgedünnten Bereich 3 mm oder weniger beträgt. Insbesondere ist dies von der Verwendung des Materials für Träger und/oder Dekor abhängig. Insbesondere, wenn wie bei einer besonderen Ausführungsform der Träger in dem ausgedünnten Bereich vollständig ausgespart ist und als Dekor Leder verwendet wird, ist eine Restwandstärke des Leders zumindest in dem schwingfähigen Bereich von höchstens 3 mm vorzusehen. Kommt als Dekor eine Kunststofffolie z. B. Kunstleder oder auch Planware zum Einsatz, so ist eine Restwandstärke von höchstens 2 mm zu wählen. Bevorzugterweise können beispielsweise Aluminiumfolien oder Kunststofffolien mit einer Stärke von 0,3 bis 0,8 mm zum Einsatz kommen, so dass keine zusätzliche Ausdünnung des Dekors erforderlich ist. Insbesondere bei der Verwendung von Aluminium ist eine Restwandstärken von unter 1 mm wünschenswert. Hierbei ist zu berücksichtigen, ob das Dekormaterial absorbierend wirkt, wie beispielsweise bei Leder oder Kunstleder oder ob es besonders steif ist, wie bei Metallen, Holz oder Stein.

Des Weiteren ist die vorliegende Erfindung auf vorteilhafte Weise auch bei Außenverkleidungen eines Fahrzeugs, vgl. z.B. DE 10 2006 012 336 A1 gemäß Oberbegriff des Anspruchs 11 der vorliegenden Erfindung, insbesondere eines Kraftfahrzeugs, wie beispielsweise den Stoßfängern, einsetzbar. Hier kommen heutzutage bereits Ultraschallsensoren zum Einsatz, die durch Öffnungen im Stoßfänger ragen (kreisrunde Ausschnitte im Stoßfänger) und somit freie Sicht auf den zu überwachenden Bereich haben. Diese können gegebenenfalls überlackiert sein, so dass die Membran und die Sichtseite des Stoßfängers das gleiche Erscheinungsbild aufweisen. Erfindungsgemäß wäre es denkbar, die Ultraschallsensoren hinter der Oberfläche (Sichtseite) des Stoßfängers anzuordnen und den Stoßfänger im Bereich der Anordnung der Ultraschallsensoren so auszudünnen, dass ein Teil des Stoßfängers selbst als Membran fungiert, wie es oben in Bezug auf das Innenausstattungsteil beschrieben wurde.

Vorteilhafte Weiterbildungen, einzelne Merkmale und besondere Ausführungsformen der vorliegenden Erfindung werden aus der folgenden Beschreibung einer bevorzugten Ausführungsform ersichtlich. Diese erfolgt unter Bezugnahme auf die begleitende Zeichnung, in der:

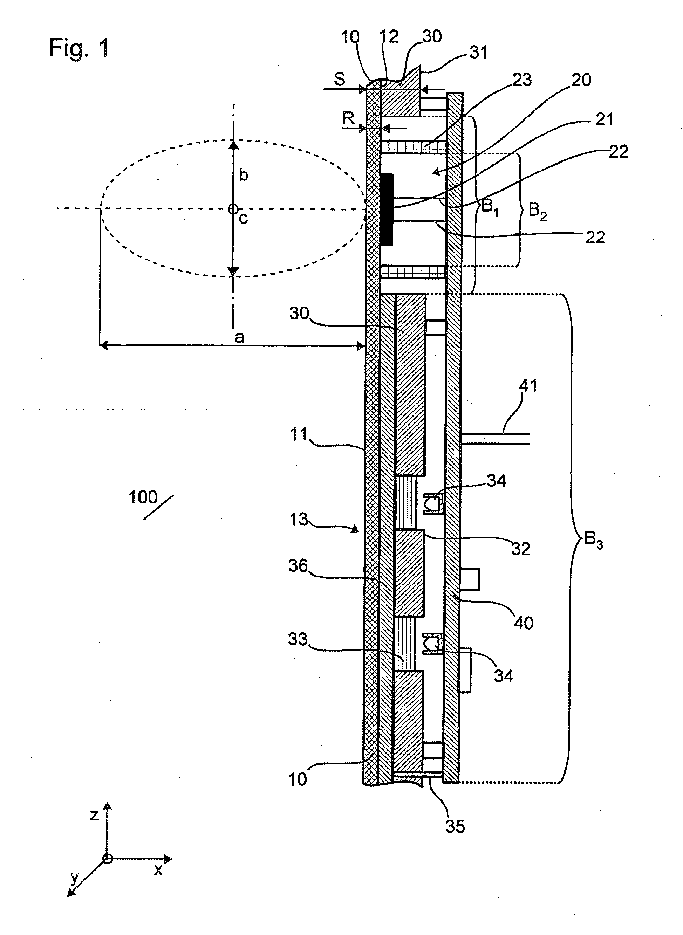

Figur 1 einen Querschnitt durch ein erfindungsgemäßes Innenausstattungsteil zeigt.

Unter Bezugnahme auf Figur 1 wird rein beispielhaft ein zentraler Bereich einer Armaturentafel als Innenausstattungsteil beschrieben. Es versteht sich jedoch, dass die folgenden Ausführungen, insbesondere in Bezug auf die Anbringung des Ultraschallsensors auch in anderen Innenausstattungsteilen und unabhängig von dem beschriebenen Bedienfeld umgesetzt werden können. Auch versteht sich, dass die vorliegende Erfindung und insbesondere die Ausgestaltungen in Bezug auf den Ultraschallsensor in einem Außenverkleidungsteil, wie beispielsweise einer Stoßstange eines Kraftfahrzeugs zum Einsatz kommen können.

In Figur 1 ist ein Innenausstattungsteil dargstellt, welches einen Verbund mit einem Träger 30 und einem Dekor 10 zeigt. Bei dem Dekor kann es sich rein beispielhaft um Echtleder, künstliches Leder (sogenannte Planware), Kunststofffolien, Holzfurnierschichten mit oder ohne Beschichtung oder gar Steinschichten handeln. Das Dekor 10 kann dabei direkt auf den Träger 30 kaschiert, d. h. mit diesem vollflächig verbunden sein. Hierfür können übliche Kaschierverfahren zum Einsatz kommen. Es ist jedoch auch denkbar zwischen dem Dekor 10 und dem Träger 30 weitere Zwischenschichten mit unterschiedlichen Funktionen vorzusehen. Rein beispielhaft sei hier eine Haptikschicht in Form eines Abstandsgewirkes (nicht dargestellt) erwähnt. Aber auch andere Zwischenschichten sind denkbar und je nach gewähltem Dekor vorzusehen.

Das Dekor 10 weist eine Sichtseite 11 auf. Die Sichtseite 11 ist bei dem dargestellten Beispiel der Fahrgastzelle 100 des Kraftfahrzeugs zugewandt und liegt für einen Betrachter in der Fahrgastzelle 100 sichtbar "frei". Weist das Dekor 10 eine Dekorschicht mit einer Beschichtung auf, so wird die Sichtseite 11 durch die der Fahrgastzelle 100 zugewandte Seite der Beschichtung gebildet. Dennoch muss das Dekor 10 sichtbar sein, wozu die Beschichtung in der Regel transparent, zumindest aber transluzent, ausgestaltet sein wird.

Die Sichtseite 11 weist im gesamten in Figur 1 dargestellten Bereich eine geschlossene kontinuierliche Oberfläche auf. D. h. die Sichtseite 11 weist keine das Dekor 10 bzw. dem Verbund vollständig durchbrechenden Öffnungen auf. Vielmehr ist die Sichtseite 11 eine ebene und glatte Oberfläche ohne Durchbrechungen und Öffnungen. Dennoch können beispielsweise im Bereich der später erläuterten Bedienelemente Vertiefungen (z. B. Fingermulden) in der Sichtseite 11 vorgesehen sein, um die Bedienelemente auch haptisch spürbar zu gestalten. Jedoch bleibt auch in diesem Fall die Oberfläche geschlossen, d. h. es sind keine Öffnung oder Durchbrechungen in dem Dekor 10 bzw. Verbund vorhanden, die von einer Seite 11 bis zur gegenüberliegenden Seite 31 laufen.

Der Verbund, der in Figur 1 rein beispielhaft aus Dekor 10 und Träger 30 aufgebaut ist, weist eine Stärke S normal, d. h. senkrecht zur Sichtseite 11, auf.

In einem Teilbereich B₁ ist der Verbund in einer Richtung normal zur Sichtseite 11, d. h. senkrecht hierzu ausgedünnt bzw. ausgespart. Bei der dargestellten Ausführungsform erfolgt die Ausdünnung derart, dass in dem Träger 30 eine vollständige Durchbrechung von der der Sichtseite 11 abgewandten Seite 31 des Trägers bis zu der Sichtseite 11 abgewandten Seite 12 des Dekors vorgesehen ist, so dass die Seite 12 des Dekors 10 im Teilbereich B₁ frei liegt. Dadurch wird im Teilbereich B₁ eine Restwandstärke R erzielt. Die Restwandstärke R wird dabei derart gewählt, dass der Verbund in dem Teilbereich B₁ ultraschallschwingfähig ist. Je nach verwendetem Dekor und Stärke des Dekors 10 kann die Restwandstärke von Dekor 10 und Träger 30, nur dem Dekor oder nur einem Teil des Dekors 10 gebildet sein. In letzterem Fall kann es gegebenenfalls notwendig sein, das Dekor 10 ebenfalls im Teilbereich B₁ auszudünnen. Dies kann beispielsweise bei einer Lederschicht durch Schärfspalten im Teilbereich B₁ erfolgen. Die Restwandstärke R beträgt bei Leder vorzugsweise höchstens 3 mm, bevorzugt weniger. Bei einer Kunststoffschicht ist es bevorzugt, die Restwandstärke auf R ≤ 2 mm und bei einer Aluminiumschicht auf R ≤ 1mm festzulegen. Bevorzugt kommen hier Aluminiumfolien zum Einsatz, die eine Stärke von 0,3 mm aufweisen. Alternative Folien weisen eine Restwandstärke von 0,6 bis 0,8 mm auf, so dass bei diesen Folien auf eine zusätzliche Ausdünnung verzichtet werden kann. Gegebenenfalls kann hier sogar im Teilbereich B₁ eine Teilschicht des Trägers 30 verbleiben, um das Dekor 10 zu stützen.

Wie es aus Figur 1 ersichtlich ist, ist rückseitig 31 an dem Träger 30 eine Platine 40 vorgesehen, die über Leitungen 41 mit einer Steuerung verbunden ist. Die Platine 40 stellt einen Teil eines Ultraschallsensors 20 dar, der einen keramischen, insbesondere piezokeramischen Geber 21 umfasst, dessen nicht dargestellte Elektroden über Leitungen 22 mit der Platine 40 und über die Leitungen 41 mit der nicht dargestellten Elektronik verbunden sind. Darüber hinaus umfasst der Ultraschallsensor 20 ein zylindrisches Element 23, das bevorzugt aus Aluminium gebildet ist. Bei der dargestellten Ausführungsform ist das zylindrische Element 23 in dem ausgedünnten Bereich B₁ des Verbunds mit der Seite 12 des Dekors 10 vollflächig verbunden, insbesondere verklebt. Alternativ ist jedoch auch ein Verschweißen denkbar. Der piezoelektrische Geber 21 ist darüber hinaus ebenfalls mit dieser Seite 12 des Dekors 10 vollflächig, insbesondere stoffschlüssig verbunden. Am meisten bevorzugt ist hier eine Klebeverbindung. Das zylindrische Element 23 wird dabei durch einen Bereich B₂ des Dekors 10 verschlossen, so dass ein Topf des Ultraschallsensors gebildet ist. In dem Bereich B₂ fungiert das Dekor 10 in diesem Fall als Membran des Ultraschallsensors 20, ist also Teil des Ultraschallsensors. Alternativ ist es auch denkbar, dass das zylindrische Element 23 durch eine Membran (nicht dargestellt) verschlossen ist, die auf einer der Rückseite 31 des Trägers 30 zugewandten Seite mit dem piezoelektrischen Geber 21 verbunden ist und andererseits vollflächig, insbesondere stoffschlüssig mit der Seite 12 des Dekors 10. Auch hier wäre eine Klebeverbindung bevorzugt. In diesem Fall würde die Schwingung der Membran ausgelöst durch den Geber 21 durch die vollflächige Verbindung der Membran mit der Rückseite 12 des Dekors 10 das Dekor 10 selbst im Teilbereich B₂ in Schwingung versetzen, so dass das Dekor 10 und die Membran gemeinsam die Membran des Ultraschallwandlers 20 bilden.

In einer Draufsicht ist das zylindrische Element 23 und damit der schwingfähige Teilbereich B₂ des Dekors 10 kreisförmig, elliptisch, rechteckig, mehreckig oder mit einer abstrakten gekrümmten Form ausgestaltet. Je nachdem wie die Sende-/Empfangscharakteristik des Ultraschallsensors 20 zu wählen ist, wird die Form, d. h. Querschnittsform, des zylindrischen Elements 23 und damit verbunden des schwingfähigen Bereichs B₂ gewählt, wie es dem Fachmann an sich bekannt ist. Zusätzlich kann zur Einstellung der Sende-/Empfangscharakteristik von der Seite 12 her eine Profilierung des Dekors 10 erfolgen, wie es der Fachmann aus der EP 0 308 899 A2 kennt. Hierzu können linienförmige Einkerbungen aber auch Perforationen und ähnliches eingebracht werden. Bei Leder bietet sich hier ein Laserbearbeitungsprozess an. Besonders bevorzugt wird die Querschnittsform des Teilbereichs B₂ und/oder die Profilierung der Rückseite 12 derart gewählt, dass die Sende-/Empfangscharakteristik des Ultraschallsensors 20 astigmatisch ist. Bei der in Figur 1 dargestellten Ausführungsform ist es dabei besonders bevorzugt, dass die Sende-/Empfangskeule ellipsoid gestaltet ist, wie es durch die Strichpunktlinien in Figur 1 angedeutet ist. Dabei ist es bevorzugt, die lange Halbachse a in Richtung der Längsrichtung (X-Richtung) des Fahrzeugs zu legen, während die Halbachsen b in Fahrzeughöhen-/vertikalrichtung (Z-Richtung) und c in Fahrzeugquerrichtung (Y-Richtung) verlaufen. Besonders bevorzugt wird die Länge der Halbachse a hierzu zwischen 30 und 100 cm betragen, während die Längen der beiden anderen Halbachsen vorzugsweise in einem Bereich zwischen 1 und 50 cm liegen werden. Die Längen der Halbachsen b und c können je nach Anforderung gleich sein oder sich unterscheiden. Das Ellipsoid, das im Querschnitt in Figur 1 dargestellt ist, deutet den überwachten Raum an. Erfolgt ein Eingriff in das Ellipsoid erkennt der Ultraschallsensor 20 den Eingriff und kann eine gewünschte Funktion auslösen. Als Beispiel einer solchen Funktion, jedoch nicht einschränkend, wird im Folgenden die Beleuchtung des weiter unten näher beschriebenen Bedienfelds erläutert. Es kann sich jedoch auch um andere Funktionen handeln. Rein beispielhaft ist die Beleuchtung einer Kartentasche bei Annäherung an die Kartentasche im Bereich einer Türinnenverkleidung zu nennen. Auch kann die Verwendung in einer Stoßstange, wie es eingangs erwähnt wurde, als Parkhilfe genannt werden. Diese Anwendungsfälle sind jedoch nicht abschließend zu verstehen.

Bei der Auslegung des Ultraschallsensors 20 ist zu berücksichtigen, dass der Ultraschallbereich weiter außerhalb des hörbaren Bereichs von Menschen und Tieren gewählt wird. Darüber hinaus soll der Schalldruck, der in der Fahrgastzelle 100 stetig vorliegt, möglichst gering gehalten werden.

Wie es aus Figur 1 ersichtlich ist, bildet das Dekor 10 eine Sichtseite 11. In dem Teilbereich B₃, hier beispielsweise unterhalb des Ultraschallsensors 20, ist ein Bedienfeld vorgesehen, das ausgestaltet ist, wie es in der DE 10 2007 013 078 A1 beschrieben ist, deren Inhalt durch Bezugnahme vollständig enthalten ist. Hierzu ist zwischen dem Dekor 10 und dem Träger 30 eine Piezofolie 36 angeordnet. In dem Dekor 10 ist eine Symbolik 13 ausgespart. Auch in dem Träger 30 befindet sich, entsprechend der jeweiligen Symbolik 13 zugeordnet, eine Aussparung 32, in der gegebenenfalls Lichtleiter 33 angeordnet sein können. Jeweils den Symboliken 13 zugeordnet, sind auf der Piezofolie 36 entsprechende Tasten, die Bedienelemente, vorgesehen. Den Aussparungen 32 bzw. Lichtleitern 33 und der Symbolik 13 zugeordnet, sitzen auf der Platine 40 LEDs 34, die im eingeschalteten Zustand die Symbolik 13 hinterleuchten und auf der Sichtseite 11 sichtbar machen. Die Piezofolie 36 ist gleichfalls mit der Platine 40 über eine Leitung 35 verbunden. Es versteht sich jedoch, dass für Ultraschallsensor 20 und Bedienfeld auch separate Platinen zum Einsatz kommen können. Insbesondere sind die Bereiche der Symbolik mit einem transluzenten Material versehen und dadurch, wie es in der DE 10 2007 013 078 A1 beschrieben ist, nur bei eingeschalteter Beleuchtung (eingeschalteten LEDs 34) sichtbar. D. h. mit Ausnahme der ausgesparten Symbolik ist die Sichtseite im Wesentlichen undurchsichtig (lichtundurchlässig). Ansonsten wirkt die Sichtseite 11 undurchsichtig und die Symbolik ist bei ausgeschalteter Beleuchtung nicht sichtbar. Alternativ kann die Beleuchtung der Symbolik auch von der Seite her erfolgen. Hierfür wird ein Lichtleiter bzw. eine lichtleitende Folie, wie sie zur Beleuchtung von LED-Displays aus der WO 2006/639315 A2, der WO 03/008860 A1 oder der WO 2005/001892 A2 bekannt sind zwischen dem Dekor 10 und der Piezofolie 36 angeordnet. Die Lichtleiter 33 können dann entfallen und die LEDs 34 emittieren Licht im Wesentlichen parallel zur Sichtseite 11 des Dekors. Für weitergehende Informationen wird der Fachmann auf die DE 10 2008 055 865 verwiesen.

Nähert sich ein Benutzer im Fahrgastraum 100 des Fahrzeugs dem Bedienfeld B₃ und greift dabei in das Ellipsoid des Ultraschallsensors 20 ein, wird ein Eingriff über die nicht dargestellte mit der Platine 40 verbundene Elektronik, die die Signale des Ultraschallsensors 20 auswertet, erkannt und die LEDs 34 werden aktiviert. Dadurch wird die Symbolik 13 hinterleuchtet und sichtbar. Der Benutzer kennt damit die Position der einzelnen Bedienelemente, die durch die Tasten der Piezofolie 36 gebildet sind. Durch Druck mit einem Finger auf die Sichtseite 11 des Dekors 10 im Bereich der Symbolik 13 werden die Piezotasten unterhalb der Symbolik betätigt und über die nicht dargestellte Elektronik der entsprechende Verbraucher bzw. das entsprechende Funktionselement angesteuert. Anschließend kann gegebenenfalls nach einem vorgegebenen Zeitfenster wieder der Standbymodus eingenommen werden, indem die LEDs 34 ausgeschaltet und die Symboliken 13 auf der Sichtseite 11 des Dekors 10 unsichtbar sind.

## Patentansprüche

1. Innenausstattungsteil eines Fahrzeugs, insbesondere eines Kraftfahrzeugs, umfassend
einen Verbund mit einem Träger (30) und einem Dekor (10) auf einer Seite des Trägers, wobei das Dekor eine vom Innenraum (100) des Fahrzeugs für einen Betrachter wahrnehmbare Sichtseite (11) umfasst, die zumindest in einem Teilbereich (B₁) eine im Wesentlichen kontinuierlich geschlossene Oberfläche aufweist, und einen Ultraschallsensor (20) mit einem Ultraschallgeber, **dadurch gekennzeichnet, dass**
der Verbund innerhalb des Teilbereichs (B₁) von der der Sichtseite abgewandten Seite her normal zur Sichtseite ausgedünnt ist und im ausgedünnten Bereich (B₁) ultraschallschwingfähig ist,
wobei der Ultraschallgeber in dem ausgedünnten Bereich (B₁) vollflächig mit der der Sichtseite (11) abgewandten Seite des Verbunds verbunden ist, so dass dieser Bereich (B₁) im Gebrauch eine Membran bildet, mit einer Frequenz im Ultraschallbereich schwingt und Ultraschallwellen aussendet, sowie durch die reflektierten Ultraschallwellen in Schwingung versetzt wird, was durch den Ultraschallgeber erkannt wird und über eine Elektronik auswertbar ist.

2. Innenausstattungsteil nach Anspruch 1, bei dem der Ultraschallgeber einen keramischen, insbesondere piezoelektrischen Geber (21) aufweist, der vollflächig mit der der Sichtseite (11) abgewandten Seite des Verbunds verbunden ist, so dass zumindest ein Abschnitt (B₂) des ausgedünnten Bereichs (B₁) des Verbunds als Membran des Ultraschallgebers fungiert.

3. Innenausstattungsteil nach Anspruch 1, bei dem der Ultraschallgeber eine Membran und einen keramischen, insbesondere piezoelektrischen Geber (21) aufweist, der mit einer Seite der Membran verbunden ist, wobei die Membran vollflächig mit der der Sichtseite (11) abgewandten Seite des Verbunds verbunden ist, so dass sich die Schwingung der Membran auf zumindest einen Abschnitt (B₂) des ausgedünnten Bereichs (B₁) des Verbunds übertragen wird.

4. Innenausstattungsteil nach einem der vorstehenden Ansprüche, bei dem der Ultraschallgeber stoffschlüssig mit der der Sichtseite (11) abgewandten Seite des Verbunds verbunden, insbesondere verklebt ist.

5. Innenausstattungsteil nach einem der vorstehenden Ansprüche, bei dem der Ultraschallsensor (20) ein zylinderförmiges Element (23) aufweist, das mit dem Ultraschallgeber oder der der Sichtseite abgewandten Seite des Verbunds verbunden ist.

6. Innenausstattungsteil nach einem der vorstehenden Ansprüche, bei dem der Ultraschallsensor eine astigmatische Sende-/Empfangscharakteristik aufweist.

7. Innenausstattungsteil nach Anspruch 6, bei dem der Ultraschallsensor eine ellipsoide Sende-/Empfangskeule mit der langen Halbachse (a) in Fahrzeuglängsrichtung und den kurzen Halbachsen (b, c) in Fahrzeugquer- und Fahrzeughöhenrichtung aufweist.

8. Innenausstattungsteil nach einem der vorstehenden Ansprüche, bei dem der Verbund in dem ausgedünnten Bereich (B₁) eine Restwandstärke (R) von 3 mm oder weniger aufweist.

9. Innenausstattungsteil nach einem der vorstehenden Ansprüche, bei dem in dem ausgedünnten Bereich (B₁) der Träger (30) vollständig ausgespart ist.

10. Innenausstattungsteil nach Anspruch 9, bei dem das Dekor (10) in dem ausgedünnten Bereich (B₁) partiell ausgedünnt ist.

11. Außenverkleidungsteil eines Fahrzeugs, insbesondere eines Kraftfahrzeugs, umfassend
einen Körper, der eine für einen Betrachter wahrnehmbare Sichtseite umfasst, die zumindest in einem Teilbereich eine im Wesentlichen kontinuierlich geschlossene Oberfläche aufweist, und einen Ultraschallsensor (20) mit einem Ultraschallgeber, **dadurch gekennzeichnet, dass**
der Körper innerhalb des Teilbereichs von der der Sichtseite abgewandten Seite her normal zur Sichtseite ausgedünnt ist und im ausgedünnten Bereich ultraschallschwingfähig ist, wobei der Ultraschallgeber in dem ausgedünnten Bereich vollflächig mit der der Sichtseite abgewandten Seite des Körpers verbunden ist, so dass dieser Bereich (B₁) im Gebrauch eine Membran bildet, mit einer Frequenz im Ultraschallbereich schwingt und Ultraschallwellen aussendet, sowie durch die reflektierten Ultraschallwellen in Schwingung versetzt wird, was durch den Ultraschallgeber erkannt wird und über eine Elektronik auswertbar ist.

12. Außenverkleidungsteil nach Anspruch 11, bei dem der Ultraschallgeber einen keramischen, insbesondere piezoelektrischen Geber aufweist, der vollflächig mit der der Sichtseite abgewandten Seite des Körpers verbunden ist, so dass zumindest ein Abschnitt des ausgedünnten Bereichs des Körpers als Membran des Ultraschallgebers fungiert.

13. Außenverkleidungsteil nach Anspruch 11, bei dem der Ultraschallgeber eine Membran und einen keramischen, insbesondere piezoelektrischen Geber aufweist, der mit einer Seite der Membran verbunden ist, wobei die Membran vollflächig mit der der Sichtseite abgewandten Seite des Körpers verbunden ist, so dass sich die Schwingung der Membran auf zumindest einen Abschnitt des ausgedünnten Bereichs des Körpers übertragen wird.

14. Außenverkleidungsteil nach einem der Ansprüche 11 bis 13, bei dem der Ultraschallgeber stoffschlüssig mit der der Sichtseite abgewandten Seite des Körpers verbunden, insbesondere verklebt ist.

15. Außenverkleidungsteil nach einem der Ansprüche 11 bis 14, bei dem der Ultraschallsensor ein zylinderförmiges Element aufweist, das mit dem Ultraschallgeber oder der der Sichtseite abgewandten Seite des Körpers verbunden ist.

## Claims

1. Interior trim part of a vehicle, in particular of a motor vehicle, comprising
a composite having a support (30) and a decorative part (10) on one side of the support, wherein the decorative part comprises a visible side (11) which can be seen by an observer from the interior (100) of the vehicle and which has a substantially continuously closed surface at least in a subregion (B₁), and comprising an ultrasound sensor (20) with an ultrasound transmitter, **characterized in that**
the composite is thinned out normal to the visible side from that side which is averted from the visible side within the subregion (B₁) and is capable of ultrasonic oscillation in the thinned-out region (B₁),
wherein the ultrasound transmitter is connected to that side of the composite which is averted from the visible side (11) over the entire area in the thinned-out region (B₁), so that, in use, this region (B₁) forms a diaphragm, oscillates at a frequency in the ultrasound range and emits ultrasound waves, and also is made to oscillate by the reflected ultrasound waves, this being identified by the ultrasound transmitter and it being possible for this to be evaluated by means of an electronics system.

2. Interior trim part according to Claim 1, in which the ultrasound transmitter has a ceramic, in particular piezoelectric, transmitter (21) which is connected to that side of the composite which is averted from the visible side (11) over the entire area, so that at least one section (B₂) of the thinned-out region (B₁) of the composite acts as a diaphragm of the ultrasound transmitter.

3. Interior trim part according to Claim 1, in which the ultrasound transmitter has a diaphragm and a ceramic, in particular piezoelectric, transmitter (21) which is connected to one side of the diaphragm, wherein the diaphragm is connected to that side of the composite which is averted from the visible side (11) over the entire area, so that the oscillation of the diaphragm is transmitted to at least one section (B₂) of the thinned-out region (B₁) of the composite.

4. Interior trim part according to one of the preceding claims, in which the ultrasound transmitter is cohesively connected, in particular adhesively bonded, to that side of the composite which is averted from the visible side (11).

5. Interior trim part according to one of the preceding claims, in which the ultrasound sensor (20) has a cylindrical element (23) which is connected to the ultrasound transmitter or to that side of the composite which is averted from the visible side.

6. Interior trim part according to one of the preceding claims, in which the ultrasound sensor has an astigmatic transmitting/receiving characteristic.

7. Interior trim part according to Claim 6, in which the ultrasound sensor has an ellipsoidal transmitting/receiving coil with the long half-axis (a) in the longitudinal direction of the vehicle and the short half-axes (b, c) in the lateral and the vertical direction of the vehicle.

8. Interior trim part according to one of the preceding claims, in which the composite has a residual wall thickness (R) of 3 mm or less in the thinned-out region (B₁).

9. Interior trim part according to one of the preceding claims, in which the support (30) is fully cut out in the thinned-out region (B₁).

10. Interior trim part according to Claim 9, in which the decorative part (10) is partially thinned-out in the thinned-out region (B₁).

11. Exterior panelling part of a vehicle, in particular of a motor vehicle, comprising a body which comprises a visible side which can be seen by an observer and which has a substantially continuously closed surface at least in a subregion, and comprising an ultrasound sensor (20) with an ultrasound transmitter, **characterized in that** the body is thinned out normal to the visible side from that side which is averted from the visible side within the subregion and is capable of ultrasonic oscillation in the thinned-out region, wherein the ultrasound transmitter is connected to that side of the body which is averted from the visible side over the entire area in the thinned-out region, so that, in use, this region forms a diaphragm, oscillates at a frequency in the ultrasound range and emits ultrasound waves, and also is made to oscillate by the reflected ultrasound waves, this being identified by the ultrasound transmitter and it being possible for this to be evaluated by means of an electronics system.

12. Exterior panelling part according to Claim 11, in which the ultrasound transmitter has a ceramic, in particular piezoelectric, transmitter which is connected to that side of the body which is averted from the visible side over the entire area, so that at least one section of the thinned-out region of the body acts as a diaphragm of the ultrasound transmitter.

13. Exterior panelling part according to Claim 11, in which the ultrasound transmitter has a diaphragm and a ceramic, in particular piezoelectric, transmitter which is connected to one side of the diaphragm, wherein the diaphragm is connected to that side of the body which is averted from the visible side over the entire area, so that the oscillation of the diaphragm is transmitted to at least one section of the thinned-out region of the body.

14. Exterior panelling part according to one of Claims 11 to 13, in which the ultrasound transmitter is cohesively connected, in particular adhesively bonded, to that side of the body which is averted from the visible side.

15. Exterior panelling part according to one of Claims 11 to 14, in which the ultrasound sensor has a cylindrical element which is connected to the ultrasound transmitter or to that side of the body which is averted from the visible side.

## Revendications

1. Pièce d'équipement intérieur d'un véhicule, notamment d'un véhicule automobile, comprenant
un assemblage muni d'un élément porteur (30) et d'un élément décoratif (10) sur un côté de l'élément porteur, l'élément décoratif comprenant un côté apparent (11) perceptible pour un observateur depuis l'espace intérieur (100) du véhicule, lequel présente au moins dans une zone partielle (B₁) une surface sensiblement fermée en continu, et un détecteur à ultrasons (20) muni d'un transducteur d'ultrasons, **caractérisée en ce que**
l'assemblage est aminci à l'intérieur de la zone partielle (B₁) depuis le côté à l'opposé du côté apparent, perpendiculairement au côté apparent, et peut osciller aux ultrasons dans la zone amincie (B₁),
le transducteur d'ultrasons étant relié sur toute la surface avec le côté de l'assemblage à l'opposé du côté apparent (11) dans la zone amincie (B₁), de telle sorte que cette zone (B₁) forme une membrane lors de l'utilisation, oscille à une fréquence dans la gamme des ultrasons et émet des ondes ultrasoniques, et aussi est amenée à osciller par les ondes ultrasoniques réfléchies, ce qui est identifié par le transducteur d'ultrasons et peut être interprété par le biais d'un circuit électronique.

2. Pièce d'équipement intérieur selon la revendication 1, avec laquelle le transducteur d'ultrasons présente un transducteur (21) en céramique, notamment piézoélectrique, lequel est relié sur toute la surface avec le côté de l'assemblage à l'opposé du côté apparent (11), de telle sorte qu'au moins une portion (B₂) de la zone amincie (B₁) de l'assemblage fait office de membrane du transducteur d'ultrasons.

3. Pièce d'équipement intérieur selon la revendication 1, avec laquelle le transducteur d'ultrasons présente une membrane et un transducteur (21) en céramique, notamment piézoélectrique, lequel est relié avec un côté de la membrane, la membrane étant reliée sur toute la surface avec le côté de l'assemblage à l'opposé du côté apparent (11), de telle sorte que l'oscillation de la membrane est transmise sur au moins une portion (B₂) de la zone amincie (B₁) de l'assemblage.

4. Pièce d'équipement intérieur selon l'une des revendications précédentes, avec laquelle le transducteur d'ultrasons est relié par adhérence de matériaux avec le côté de l'assemblage à l'opposé du côté apparent (11), notamment collé.

5. Pièce d'équipement intérieur selon l'une des revendications précédentes, avec laquelle le détecteur à ultrasons (20) présente un élément de forme cylindrique (23) qui est relié avec le transducteur d'ultrasons ou le côté de l'assemblage à l'opposé du côté apparent.

6. Pièce d'équipement intérieur selon l'une des revendications précédentes, avec laquelle le détecteur à ultrasons présente une caractéristique d'émission/de réception astigmatique.

7. Pièce d'équipement intérieur selon la revendication 6, avec laquelle le détecteur à ultrasons présente un lobe de rayonnement d'émission/de réception ellipsoïdal avec le demi-axe long (a) dans le sens longitudinal du véhicule et les demi-axes courts (b, c) dans le sens transversal du véhicule et de la hauteur du véhicule.

8. Pièce d'équipement intérieur selon l'une des revendications précédentes, avec laquelle l'assemblage présente dans la zone amincie (B₁) une épaisseur de paroi résiduelle (R) de 3 mm ou moins.

9. Pièce d'équipement intérieur selon l'une des revendications précédentes, avec laquelle l'élément porteur (30) est entièrement évidé dans la zone amincie (B₁).

10. Pièce d'équipement intérieur selon la revendication 9, avec laquelle l'élément décoratif (10) est partiellement aminci dans la zone amincie (B₁).

11. Pièce d'habillage extérieur d'un véhicule, notamment d'un véhicule automobile, comprenant
un corps qui comprend un côté apparent perceptible pour un observateur, lequel présente au moins dans une zone partielle une surface sensiblement fermée en continu, et un détecteur à ultrasons (20) muni d'un transducteur d'ultrasons, **caractérisée en ce que**
le corps est aminci à l'intérieur de la zone partielle depuis le côté à l'opposé du côté apparent, perpendiculairement au côté apparent, et peut osciller aux ultrasons dans la zone amincie, le transducteur d'ultrasons étant relié sur toute la surface avec le côté du corps à l'opposé du côté apparent dans la zone amincie, de telle sorte que cette zone (B₁) forme une membrane lors de l'utilisation, oscille à une fréquence dans la gamme des ultrasons et émet des ondes ultrasoniques, et aussi est amenée à osciller par les ondes ultrasoniques réfléchies, ce qui est identifié par le transducteur d'ultrasons et peut être interprété par le biais d'un circuit électronique.

12. Pièce d'habillage extérieur selon la revendication 11, avec laquelle le transducteur d'ultrasons présente un transducteur en céramique, notamment piézoélectrique, lequel est relié sur toute la surface avec le côté du corps à l'opposé du côté apparent, de telle sorte qu'au moins une portion de la zone amincie du corps fait office de membrane du transducteur d'ultrasons.

13. Pièce d'habillage extérieur selon la revendication 11, avec laquelle le transducteur d'ultrasons présente une membrane et un transducteur en céramique, notamment piézoélectrique, lequel est relié avec un côté de la membrane, la membrane étant reliée sur toute la surface avec le côté du corps à l'opposé du côté apparent, de telle sorte que l'oscillation de la membrane est transmise sur au moins une portion de la zone amincie du corps.

14. Pièce d'habillage extérieur selon l'une des revendications 11 à 13, avec laquelle le transducteur d'ultrasons est relié par adhérence de matériaux avec le côté du corps à l'opposé du côté apparent, notamment collé.

15. Pièce d'habillage extérieur selon l'une des revendications 11 à 14, avec laquelle le détecteur à ultrasons présente un élément de forme cylindrique qui est relié avec le transducteur d'ultrasons ou le côté du corps à l'opposé du côté apparent.
